Europäisches Patentamt

European Patent Office

Office européen des brevets

(11) Publication number: **0 414 204 A2**

# EUROPEAN PATENT APPLICATION

(21) Application number: **90115984.8**

(51) Int. Cl.⁵: **H01L 23/538**, H01L 23/50

(22) Date of filing: **21.08.90**

(30) Priority: **21.08.89 JP 214542/89**

(43) Date of publication of application:
**27.02.91 Bulletin 91/09**

(84) Designated Contracting States:
**DE GB**

(71) Applicant: **HITACHI, LTD.**
**6, Kanda Surugadai 4-chome**
**Chiyoda-ku, Tokyo 101(JP)**

(72) Inventor: **Idei, Akio**
**3-31-23, Shibusawa**
**Hadano-shi, Kanagawa-ken(JP)**
Inventor: **Horita, Yoshiaki**
**204 Family-Heights, 547, Hirasawa**
**Hadano-shi, Kanagawa-ken(JP)**

(74) Representative: **Altenburg, Udo, Dipl.-Phys. et al**
**Patent- und Rechtsanwälte**
**Bardehle-Pagenberg-Dost-Altenburg**
**Frohwitter-Geissler & Partner Postfach 86 06 20**
**D-8000 München 86(DE)**

(54) **Multilayer interconnection substrate and semiconductor integrated circuit device using the same.**

(57) A multilayer interconnection substrate including signal layers, power supply layers, insulating layers for electrically insulating the layers, and interconnecting paths. The signal layers, the power supply layers, and the insulating layers are superposed. Component connection terminals are mounted on a component mounting surface of the multilayer interconnection substrate for connecting to components. External connection terminals are mounted to another surface of the multilayer interconnection substrate. At least one power supply matching layer is layered above both the signal layers and the power supply layers through a insulating layer and close to the component mounting surface. The power supply matching layer corresponds in voltage to a component to be mounted to the component mounting surface. The power supply matching layer is connected to corresponding component power supply terminals, corresponding power supply layers, and corresponding external power supply terminals through the interconnecting paths.

## FIG. 1

# MULTILAYER INTERCONNECTION SUBSTRATE AND SEMICONDUCTOR INTEGRATED CIRCUIT DEVICE USING THE SAME

## BACKGROUND OF THE INVENTION

### 1. Field of the Invention

The present invention relates to a multilayer interconnection substrate and a semiconductor integrated circuit device using the same. The multilayer interconnection substrate is suitably but not exclusively used for mounting a combination of circuit components, such as semiconductors, having a variety of supply voltages, number of pins and sizes.

### 2. Related Art

The multilayer interconnection substrate is used for mounting semiconductor components such as large scale integrated (LSI) circuit. The multilayer interconnection substrate has ceramic layers laminated each other, each layer having a conductor layer printed on it. Through holes are formed through layers to interconnect conductors. The multilayer interconnection substrate has one major surface serving as a component mounting surface and the other major surface serving as a pin connection surface.

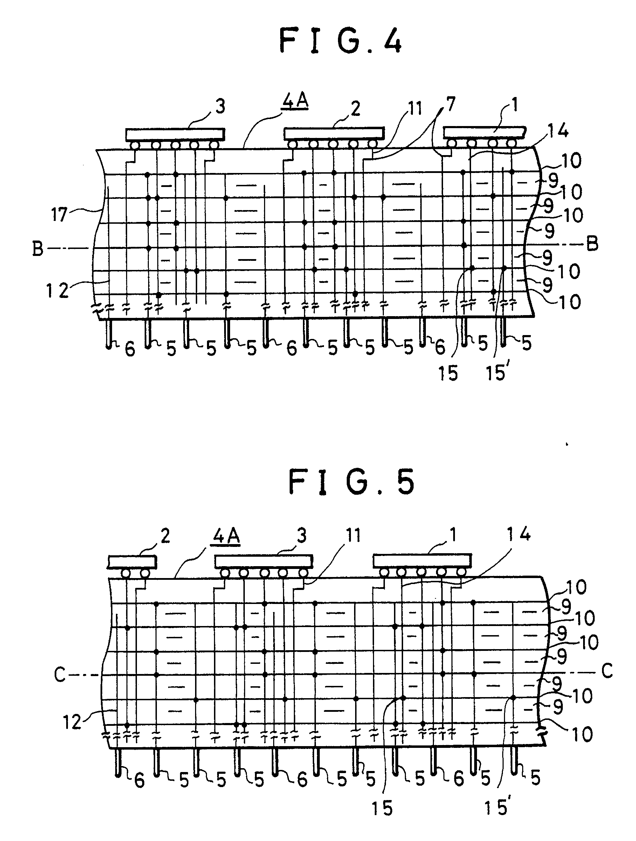

The conductor layers of the multilayer interconnection substrate includes signal layers and power supply layers, the former transmitting signals and the latter performing power supplying or impedance matching. There are two types of such a multilayer structure: one type of structure laminates the power supply layers and the signal layers in two groups separate from each other; and the other sandwiches each signal layer between adjacent power supply layers. The latter is larger in the number of layers than the former but is superior in impedance matching and reduction of cross talk. Typical structures of the conventional multilayer interconnection substrate are disclosed in Nikkei Science, Japan, Vol.13, No.9 (1983), pp.13-25, and 19th Design Automation Conference Paper 9.4, pp.96-103 "pp99 Figure 5", for example.

The multilayer interconnection substrates are fabricated as follows: materials are mixed and formed into sheets, so called green sheets; the green sheets are punched to form through holes: then, a conductor pattern, such as a pattern for a power supply layer, a signal layer, or the like, is imprinted on each green sheet with a print mask having a predetermined pattern; these green sheets are laminated and sinterd; finally the laminate is subjected to a finish treatment such as plating.

Various semiconductor devices such as LSI circuits are mounted on the multilayer interconnection substrates for various specific use, and many levels of voltage sources are needed for the semiconductor devices. Thus, many superposed power supply layers are prepared for this requirement.

Patterns of the power supply layers and the signal layers depend on the kind and the layout of the LSI circuits mounted. The patterns of the power supply layers and the signal layers must be changed, for example, when semiconductor components which are different in supply voltage, the number of pins, size, etc are mounted, or when the arrangement of the semiconductor components is changed. For this reason, a new multilayer interconnection substrate having different patterns of power supply layers and signal layers must be prepared for a different combination of LSI circuits or a different layout.

Such multilayer interconnection substrates are produced on a many-kind-small-amount production basis, and hence many print masks with different conductor patterns must be prepared. The more the varieties of semiconductor components to be mounted increase, the more the conductor patterns are needed. To fabricate a multilayer interconnection substrate with a different specification, it is necessary to design new conductor patterns and to produce new masks to print them with. Thus, the fabrication of the multilayer interconnection substrate according to the prior art requires many manhours.

Through holes must be changed in position due to modification of the conductor patterns. Accordingly, it is necessary to change tools for punching, inspection jigs, etc. These make the fabrication process rather complicated and thus it is not easy to simplify and facilitate fabrication of the multilayer interconnection substrate.

Moreover, input/output pins of the multilayer interconnection substrate are changed in position according to modifications in conductor patterns and shifts of through holes. According to circumstances, there might be a need to modify the pattern of the printed wiring board on which the multilayer interconnection substrate is mounted.

The drawbacks stated above bar against reduction in fabrication cost of the multilayer interconnection substrate and time necessary to produce and deliver it. However, no attempt has been made to overcome such a problem in production of the multilayer interconnection substrate.

## SUMMARY OF THE INVENTION

It is therefore an object of the present invention to provide a multilayer interconnection substrate which is capable of standardizing part of the conductor patterns to thereby reduce both the manhour of designing the multilayer interconnection substrate and the number of print masks necessary for providing the multilayer interconnection substrate, facilitating the fabrication thereof.

It is another object of the present invention to provide a semiconductor integrated circuit device using the multilayer interconnection substrate.

With these and other objects in view, the present invention provides a multilayer interconnection substrate including: signal layers; power supply layers; at least one power supply matching layer provided to correspond in voltage to components to be mounted; and insulating layers electrically insulating the layers from each other. The at least one power supply matching layer is provided in the form of a bus-bar layer which is layered above both the signal layers and the power supply layers and close to the component mounting surface, so that the components may be connected to the power supply layers of the desired voltages through the bus-bar layer or layers of said desired voltages, respectively.

According to one aspect of the present invention, there is provided a multilayer interconnection substrate of the type including a component mounting surface, comprising: signal layers; power supply layers; at least one power supply matching layer, provided above both the signal layers and the power supply layers and close to the component mounting surface, the power supply matching layer corresponding in voltage to a component to be mounted to the component mounting surface; insulating layers for electrically insulating the signal layers, the power supply layers and the power supply matching layer from each other; the signal layers, the power supply layers, the power supply matching layer and the insulating layers being laminated to form the substrate; component connection terminal means, disposed on the component mounting surface for connection to the components; the component connection terminal means including component power supply terminals; external connection terminal means disposed on another surface of the multilayer interconnection substrate; the external connection terminal means including external power supply terminals; and interconnecting means; the interconnecting means including: first power supply interconnection means for interconnecting the power supply matching layer to corresponding component power supply terminals; second power supply interconnection means for interconnecting the power supply matching layer to corresponding power supply layers; and third power supply interconnection means for interconnecting the power supply matching layer to corresponding external power supply terminals.

According to the present invention, a power matching layer is layered above both the signal layers and the power supply layers and close to the component mounting surface. When a semiconductor component which is different in power supply position from usual semiconductors is mounted to the component mounting surface, misalignment is caused in the power supply position of the semiconductor component, which is absorbed by the power supply matching layer. The misalignment is also absorbed by the power supply matching layer when the mounting layout of the semiconductor component is modified. Thus, changes in power supply position due to modifications in components to be mounted and in layout exert no influence on the positions of interconnection means in layers below the power supply matching layer: the signal layers and the power supply layers. Thus in various multilayer interconnection substrates, the present invention is capable of reducing the manhour necessary for each of the design, fabrication of masks, the production process, inspection of the product, and other treatments.

The signal layers, the power supply layers and the power supply matching layer may have each a corresponding conductor pattern which is sandwiched between adjacent insulating layers; and the interconnecting means may comprise through holes formed through at least some of the insulating layers.

According to another aspect of the present invention, there is provided a multilayer interconnection substrate having component mounting surfaces for mounting components thereon, comprising: signal layers; power supply layers; at least two power supply matching layers which are respectively layered above and below both the signal layers and the power supply layers and close to the component mounting surfaces; each power supply matching layer being provided to correspond to respective voltages of the components to be mounted to the component mounting surfaces; insulating layers for electrically insulating the signal layers, the power supply layers and the power supply matching layer from each other; said signal layers, said power supply layers, said power supply matching layers and the insulating layers being superposed into a laminate; component connection terminal means, mounted to the component mounting surfaces, respectively, for connection to the components; said component connection terminal means including component power supply terminals; external connection terminal means mounted to another surface of the multilayer interconnection substrate; said external connection terminal means including external power supply terminals; and interconnecting means including: first power supply interconnection means for interconnecting said power supply matching layers to corresponding component power supply terminals; second power supply interconnection means for interconnecting the power supply matching layer to corresponding power supply layers; and third power supply interconnection means for interconnecting said power supply matching layer to corresponding external power supply terminals.

Preferably, an external connector is provided to another, side surface of the multilayer interconnection terminal for connection with the external power supply terminals and the external signal terminals.

In the present invention, components to be mounted to the component mounting surface may include semiconductor chips such as LSI chips.

In another preferred mode of the present invention, the component connection terminal means comprises signal terminals; the external connection terminal means comprises external signal terminals; and the interconnecting means comprises: first signal interconnection means for interconnecting the signal terminals of the component connection terminal means to corresponding signal layers; and second signal interconnection means for interconnecting the external signal terminals of the external connection terminal means to corresponding signal layers. Input/output (I/O) pins are connected to respective external signal terminals and external power supply terminals.

In a still preferred mode of the present invention, the component connection terminal means comprises signal terminals. The external connection terminal means comprises external signal terminals. The interconnecting means comprises: first signal interconnection means for interconnecting the signal terminals of the component connection terminal means to corresponding signal layers; and second signal interconnection means for interconnecting the external signal terminals of the external connection terminal means to corresponding signal layers. Both the signal terminals and the power supply terminals of the first component connection terminal means are separated in groups, each group being arranged at a corresponding chip site on the component mounting surface, the chip site being adapted to have a corresponding component mounted thereat.

The first power supply interconnection means and the first signal interconnection means may have each the same arrangement pattern as to every group of component connection terminal means.

The present invention may be applied to a chip carrier. The chip carrier comprises at least one power supply matching layer corresponding in voltage to a semiconductor chip and insulating layers sandwiching the power supply matching layer. The insulating layers and the power supply matching layer are laminated. Chip connection terminal means is disposed on one surface of the chip carrier for connection to the semiconductor chip, the chip connection terminal means including chip power supply terminals. Substrate connection terminal means is disposed on the other surface of the chip carrier for connecting to a multilayer interconnection substrate. The substrate connection terminal means includes substrate power supply terminals. Interconnecting means is provided to interconnect each of both the chip power supply terminals and the substrate power supply terminals to a corresponding power supply matching layer.

According to the present invention, a semiconductor integrated circuit may be built by mounting a semiconductor chip on the multilayer interconnection substrate as stated above with or without the chip carrier already described.

## BRIEF DESCRIPTION OF THE INVENTION

In the drawings:

FIG. 1 is a schematic vertical cross-sectional view illustrating a first embodiment of the present invention;

FIG. 2 is a schematic vertical cross-sectional view of a second embodiment of the present invention;

FIG. 3 is a sectional view taken along the line A-A in FIGS. 1 and 2;

FIGS. 4 and 5 are schematic vertical cross-sectional views showing conventional multilayer interconnection substrates;

FIG. 6 is a sectional view taken along the line B-B in FIG. 4;

FIG. 7 is a sectional view taken along the line C-C in FIG. 5;

FIG. 8 is a schematic vertical cross-sectional view of a third embodiment of the present invention; and

FIG. 9 is a schematic vertical cross-sectional view of a fourth embodiment of the present invention.

## DETAILED DESCRIPTION OF THE EMBODIMENTS

Several embodiments of the present invention will be described with reference to the drawings hereinafter. In the drawings, corresponding elements are designated by the same reference numerals and descriptions thereof will be omitted or simplified.

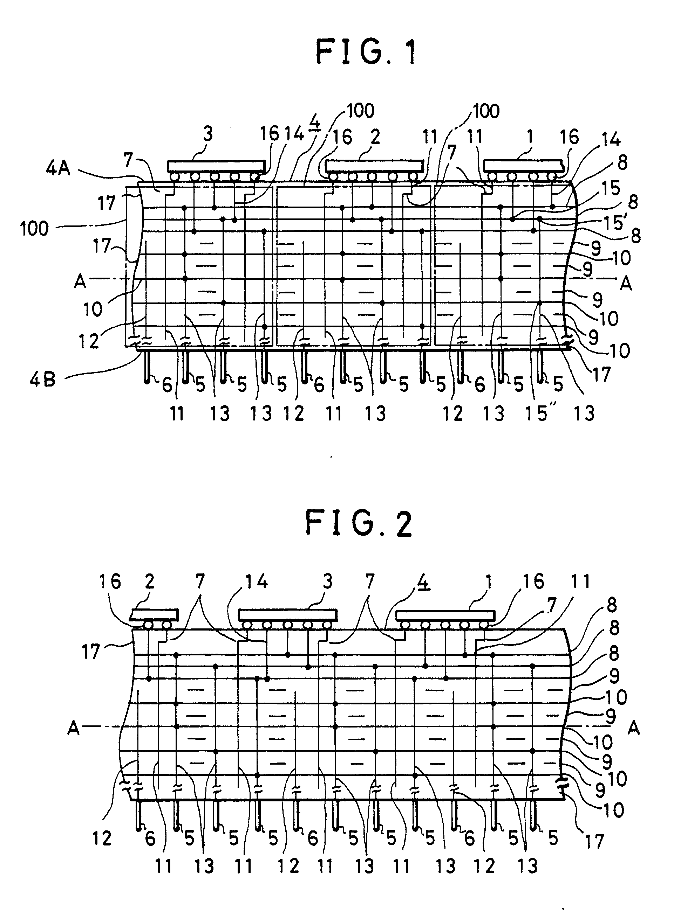

In FIG. 1, reference numerals 1, 2 and 3 indicate semiconductor chips, which have different supply voltages at power supply bumps on their substrate interconnection surfaces.

Reference numeral 4 designates a multilayer interconnection substrate, 5 input/output (I/O) pins for supplying power, 6 I/O pins for signals, 7 an enlarged layer, 8 power supply matching layers in the form of bus-bar layers, 9 signal layers, and 10 power supply layers. Each of the power supply layers 10 serves an impedance matching layer as well as a power supply layer.

Reference numerals 11, 12, 13 and 14 indicate through holes constituting interconnection paths: 11 designates signal through holes connected to corresponding semiconductor chips 1, 2 and 3; 12 signal through holes connected to corresponding power supply I/O pins 5 and signal I/O pins 6; 13 power supply through holes connected to corresponding I/O pins, respectively; and 14 power supplying through holes connected to corresponding semiconductor chips.

In this embodiment, the multilayer interconnection substrate 4 includes the enlarged layer 7, power supply matching layers 8 provided in the form of bus-bar layers, signal layers 9, power supply layers 10 and through holes 11, 12, 13, and 14 connecting these elements.

The enlarged layer 7 is an interconnecting layer to match corresponding through holes 11 and bumps 16 which are connected to semiconductor chips to be mounted. The enlarged layer 7 may be omitted.

The power supply matching layers 8 are provided to correspond to voltages of the semiconductor chips 1 to 3 to be mounted. That is, when three voltages are needed for these semiconductor chips 1 to 3, three layers of power supply matching layers 8 are formed. Thus, the power supply matching layers 8 are designed to correspond to various layouts and semiconductor components to be mounted.

Each of the signal layers 9 is used for transmitting signals and is connected to a corresponding signal through hole 12 and signal through hole 11 to transmit a signal. In FIG. 1, one signal layer 9 is provided for every power supply layer 10, but two signal layers 9 may be formed for every power supply layer 10. The interconnection patterns of the signal layers 9 are designed according to the kinds of semiconductor components to be mounted and a layout thereof.

The power supply layers 10 are formed so that adjacent power supply layers 10 may sandwich one signal layer 9. The power supply layers 10 serve to supply electric power and to match impedance. The power supply layers 10 are provided to correspond to signal layers 9. It is to be noted that the power supply layers 10 each have a fixed pattern for connection with or non-connection with to the power supply through holes 13 as well as a fixed pattern for connection with or non-connection with the through holes 11 and 12. Accordingly, it suffices to use several predetermined conductor patterns of each power supply layer 10 irrespective of sorts of semiconductor components to be mounted and layouts.

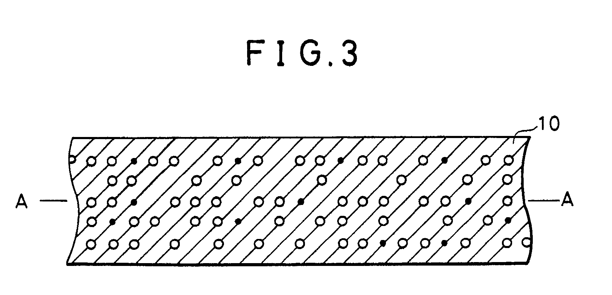

The conductor pattern of each power supply layer 10 is formed, for example, as shown in FIG. 3 which is a view taken along the line A-A in FIG. 1. In FIG. 3, hatching shows conductors formed. The hollow circles indicate through holes which pass without making electrical contact with the conductors whereas the solid circles are through holes which electrically connect to the conductors.

The enlarged layer 7, the power supply matching layers 8, the signal layers 9 and the power supply layers 10 are formed by imprinting previously designed patterns on a green sheet, layering the green sheets thus prepared, and sintering them, for example. Adjacent layers of these layers are insulated by one interposed insulating layer 17.

In forming these layers, the through holes 11 to 14 are simultaneously formed. The through holes 11 to 14 are fabricated by forming holes through the enlarged layer 7, the signal layers 9, the power supply layers 10, insulating layers 17 and the power supply matching layers 8 and then by charging an electrically conductive material into the holes. To connect to a layer, through holes 11 to 14 are electrically connected to the conductor pattern thereof.

One end of each of the through holes 11 to 14 is connected to the corresponding signal terminal or corresponding power supply terminal, but the one end itself may be used as a signal terminal or a power supply terminal.

The bumps 16 are connected to corresponding signal terminals of the through holes 11 and power supply terminals of the through holes 14.

Signal terminals of the through holes 12 and power supply terminals of the through holes 13 are connected to corresponding signal I/O pins 6 and power supply I/O pins 5, respectively.

The multilayer interconnection substrate is provided on its one major plane with different kinds of semiconductor chips 1 to 3 (only three of which are shown) and on the other major plane with the power supply I/O pins 5 and the signal I/O pins 6 connected to it by brazing.

As shown in FIG. 1, each of the through holes 11 which is connected at its upper end to the corresponding semiconductor component extends to the lowermost signal layer. Each signal through hole 12 connected to the corresponding I/O pin 6 extends to the uppermost signal layer. Each through hole 14 which is connected at one end to the power supply bump 16 of the corresponding semiconductor chip is connected at the other end to the power supply matching layer 8 at a connecting point 15. Each of the power supply through holes 13 extends downwards from a connecting point $15'$ and is connected to a connecting point $15''$ on the way and at its lower end to the corresponding power supply I/O pin 5.

In FIG. 1, the multilayer interconnection substrate 4 absorbs the misalignment of power supply bumps of various kinds of semiconductor chips 1 to 3 by the power supply matching layers 8, although the semiconductor chips 1 to 3 are mounted on the same component mounting surface thereof. As shown, the signal layers 9 and the impedance matching/power supply layers 10 repeat the same pattern of interconnection with corresponding through holes 13 for every chip site 100 irrespective of chips 1 to 3. Each of the signal through holes 11 which are connected to respective semiconductor chips 1, 2 and 3 is shiffed to a standardized position at the enlarged layer 7. The signal through holes 11 extend downwardly to the lowermost signal layer 9. Thus, the power supply layers 10 and the through holes 11 to 13 are the same in position for each chip site 100 .

A second embodiment of the present invention will be described hereinafter. FIG. 2 illustrates a vertical schematic cross-sectional view of another multilayer interconnection substrate taken along the same line as the multilayer interconnection substrate of FIG. 2.

The second embodiment is distinct in mounting layout of semiconductor chips from the embodiment of FIG. 1, but semiconductor chips 1 to 3 of Fig. 2 are the same as the semiconductor chips 1 to 3 of FIG. 1.

In FIG. 2, the position of each of the power supply layers 10 and the position of each of the through holes 11, 12 and 13 are the same as in FIG. 1. The enlarged layer 7 and the power supply matching layers 8 absorb all the changes in mounting layout of the semiconductor chips 1 to 3, and hence the pattern of each of the power supply layers 10, the signal through holes 11 and 12 and the power supply through holes 13 of FIG. 2 is the same as in FIG. 1. Accordingly, the cross-sectional view taken along the line A-A in FIG. 2 is the same as in FIG. 1 as shown in FIG. 3.

As stated, the arrangement of the enlarged layer and the power supply matching layers on the side of the component mounting surface makes it unnecessary to redesign the power supply layers 10 below the power supply matching layers to mount different kinds of semiconductor chips according to a different layout. It is simply needed to redesign the enlarged layer and the power supply matching layers for a new layout. The I/O pins may be commonly used for any mounting layout of semiconductor chips.

This feature will be illustrated in more detail with reference to FIGS. 4-7. FIG. 4 shows a conventional multilayer interconnection layer 4A without any power supply matching layer. The multilayer interconnection layer 4A has semiconductor chips 1 to 3, which are the same as those of FIG. 1, mounted on it for comparison with the present invention. FIG. 5 illustrates a conventional multilayer interconnection layer 4A in which the layout of semiconductor chips 1 to 3 is modified as in the embodiment of FIG. 2.

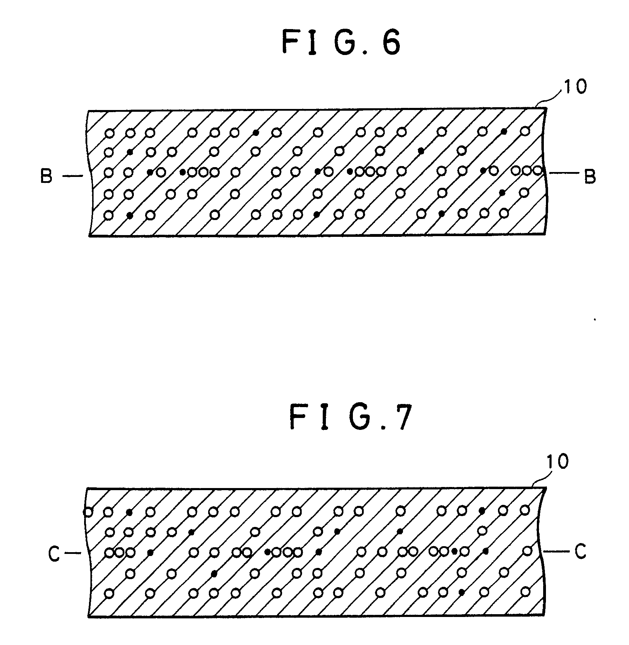

FIGS. 6 and 7 show cross-sectional views taken along the lines B-B and the C-C in FIGS. 4 and 5, respectively.

It will be noted by comparing FIGS. 6 and 7 that two multilayer interconnection substrates are different in position of each of noncontact through holes (hollow circle) and connected through holes (solid circle). Thus, it is necessary to design different conductor patterns for these multilayer interconnection substrates. In contrast, the first and second embodiments of the present invention have the same pattern of the corresponding power supply layer 10 as shown in FIG. 3, and hence the corresponding power supply layers 10 have the same design pattern.

In the first and the second embodiments, each of the power supply layers, signal pins and power supply pins are standardized for the power supply system, including impedance matching system, of a variety of multilayer interconnection substrates. Thus, man-hours of design and the number of printing masks for the power supply system are fairly reduced and thereby the production cost is reduced.

Moreover, in the first and second embodiments, the design of the power supply system of multilayer interconnection substrates is carried out in the common power supply layers, the component mounting layer, which corresponds to each component to be mounted, the enlarged layer and the power supply matching layers, and it is possible to design the power supply system other than the signal layers. Thus, the man-hours of the design and the production cost are further reduced.

In the first and the second embodiments, the design of the signal layers is performed in view of the position of each through hole fixed according to standardization of signal pins. Thus, it is possible to independently design the power supply system and the signal system in view of the standardized portions.

The arrangement of the I/O pins is standardized irrespective of the layout of the component mounting plane. Thus, each through hole is standardized in position as well as the power supply layers. This simplifies the processes of punching, inspection, etc, thereby considerably reducing the production cost. In many-kind-small-amount basis production, the manufacturing cost takes a large part of the price of the product. Thus, the reduction in manufacturing cost due to reduction in both design manday and in the number of masks fully absorbs a raise in cost due to the increase of power supply matching layers and provides a considerable profit.

Moreover, the multilayer interconnection substrates of the first and the second embodiments provide a printed wiring board to which they are mounted with an advantage of standardized wiring layout of I/O pins.

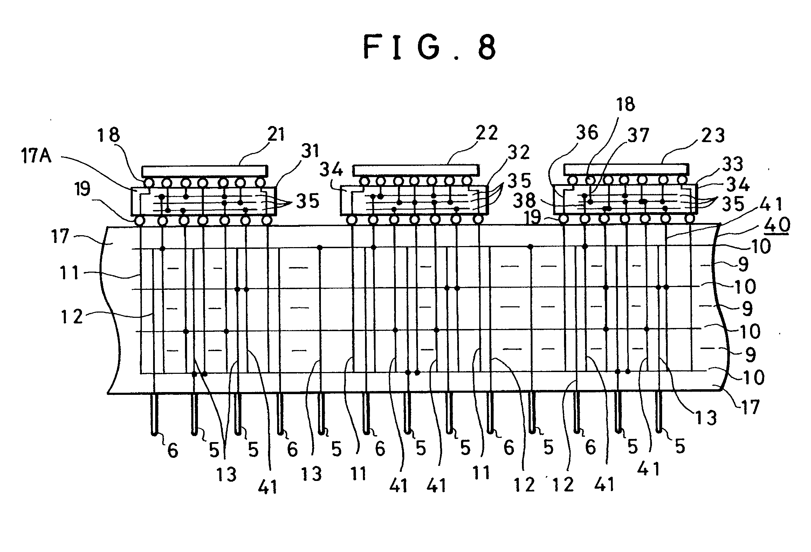

FIG. 8 schematically illustrates a third embodiment of the present invention. In this embodiment, power supply matching layers are provided to chip carriers.

In this embodiment, semiconductor chips 21, 22, and 23 are mounted on respective chip carriers 31, 32, and 33, which are in turn mounted on a multilayer interconnection substrate 40.

The multilayer interconnection substrate 40 is provided with signal layers 9, power supply layers 10, and through holes 11 to 13 and is further provided with I/O pins 5 and 6. The multilayer interconnection substrate 40 has the same structure as the multilayer interconnection substrates of the first and the second embodiments except that the enlarged layer 7 and the power supply matching layers 8 are not provided. Also, in the third embodiment, through holes 11 and 13 are formed at the same positions in a similar manner for respective chip sites.

In the third embodiment, the electrical connection between power supply matching layers 35 of the chip carriers 31 to 33 and power supply layers 10 of the multilayer interconnection substrate 40 is made by connecting through holes 38 of chip carriers 31 to 33 to through holes 41 of multilayer interconnection substrate 40 through power supply bumps 19. This connection is distinct from the connection in the first embodiment of FIG. 1.

Each of the through holes 36, 37 and 38 constitutes a chip connecting terminal portion at one end thereof on the side of the semiconductor chip mounting surface and a substrate connecting terminal portion at the other end on the side of the opposite surface to be placed on the multilayer interconnection substrate 40. The opposite ends of each through hole 36, 37, 38 are connected to power supply bumps 18 and 19, respectively.

Each of the chip carriers 31, 32 and 33 is provided on its one surface with power supply bumps 18 for corresponding one of the semiconductor chips 21, 22 and 23. The power supply bumps 18 are connected to the chip connecting terminal portions of corresponding through holes 36, 37 and 38. Connected to the other surface of each chip carrier 31, 32, 33 are power supply bumps 19 for the multilayer interconnection substrate 40. The power supply bumps 19 are connected to substrate connecting terminal portions of corresponding through holes 36, 37 and 38. The chip carriers 31, 32 and 33 are each provided with an enlarged layer 34 and power supply matching layers 35. The enlarged layer 34 and power supply matching layers 35 are each sandwiched between adjacent insulating layers 17A as in the first embodiment.

Each of the enlarged layers 34 absorbs misalignment between corresponding power supply bumps 18 and 19 and connects them through a through hole 36.

The power supply matching layers 35 are provided in a number to correspond to voltages of semiconductor chips to be mounted. The power supply matching layers 35 are connected to power supply bumps 18 through through holes 37 and to power supply bumps 19 through through holes 38. Several through holes 37 and 38 are provided to correspond to power supply bumps 18 and 19, respectively.

In the third embodiment, the power supply matching layers 35 of the chip carrier 31, 32, and 33 meet changes in power supply condition due to a variety of semiconductor chips and modification of the layout as shown in FIG. 8. Thus, it is possible to standardize the power supply layers 10, the through holes 11 to 13 and the I/O pins 5 and 6 of the multilayer interconnection substrate 40. In designing a multilayer interconnection substrate 40 on which different semiconductor chips are mounted, the signal layers 9 and the chip carriers 31 to 33 may be designed independently, and hence the third embodiment achieves reduction in both the manhour of design and the number of masks of the multilayer interconnection substrate and moreover facilitates production thereof. Thus, the time to develop the multilayer interconnection substrate and the cost of production thereof are reduced.

Although in the embodiment of FIG. 8, enlarged layers 34 are provided to the chip carriers 31, 32, and 33, they may be omitted.

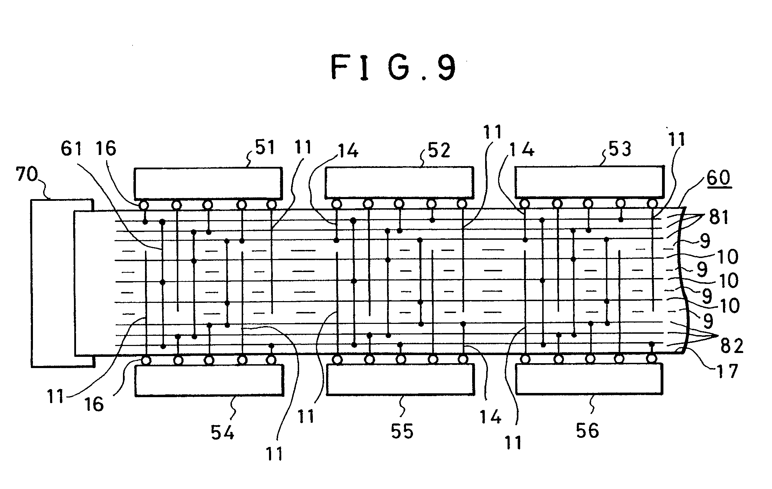

A fourth embodiment of the present invention is illustrated in FIG. 9, in which the multilayer interconnection substrate has semiconductor chips mounted on its opposite surfaces; the two principal planes of the multilayer interconnection substrate serve as semiconductor element component mounting planes. One end surface (the left side end surface) of the multilayer interconnection substrate serves as a connector fitting surface.

In a multilayer interconnection substrate 60 of the fourth embodiment, signal layers 9 and power supply layers 10 are superposed. In FIG. 9, there are four signal layers 9 and three power supply layers 10. Power supply matching layers 81 are laid as top layers and power supply matching layers 82 as bottom layers. The power supply matching layers 81 and 82 are superposed through insulating layers 17.

The multilayer interconnection substrate 60 is provided on its opposite major surfaces with bumps 16 for connecting to semiconductor chips 51 to 56. The multilayer interconnection substrate 60 is further provided with through holes 11 for connection with signal layers 9 and with through holes 14 for connection with power supply matching layers 81 or 82. Through holes 61 are also formed in the multilayer interconnection substrate 60 to interconnect power supply matching layers 81 and 82.

In the fourth embodiment, input and output of signals and electric power are performed through the connector 70. The multilayer interconnection substrate 60 is provided on its one end with leads (not shown) of the power supply matching layers 81 and 82, the signal layers 9 and the power supply layers 10 for connection to the connector 70. The leads are provided with connection pins and a fitting mechanism (both not shown). More than one connector 70 may be provided.

Semiconductor chips are mounted on opposite planes of the multilayer interconnection substrate 60, and hence the density of chip mounting for a single substrate is raised. The power supply matching layers must be increased as the semiconductor chips to be mounted to the multilayer interconnection substrate 60 increase. In this embodiment, this requirement is met by increasing the power supply matching layers 81 and 82 without any adverse effect on the power supply layers 10. That is, without modifying the conductor pattern and the through holes, a variety of semiconductor chips may be mounted on the multilayer interconnection substrate 60, and the multilayer interconnection substrate 60 which enables various layouts may be produced with reduced manhour of design. The fourth embodiment also provides the same advantages in ease of production and reduction of fabrication cost as the preceding embodiments.

It is possible to combine the multilayer interconnection substrate of the fourth embodiment with that of FIG. 8. In this case, power supply matching layers 81 or 82 are incorporated in each of the chip carriers.

In each of the preceding embodiments, the number of the power supply matching layers may be changed to correspond to the design of the multilayer interconnection substrate on which semiconductor chips with a variety of voltages are mounted. For an increase of signal layers, the power supply layers which function as both impedance matching layers and power supply layers are increased. To do this, it is only necessary to determine additional connecting points of power supply layers to through holes, and thus, time and labor to redesign the multilayer interconnection substrate are eliminated.

In the preceding embodiments, each of the power supply layers below or inside the power supply matching layers of the multilayer interconnection substrates has the same pattern even if different sorts of semiconductor chips are mounted with a different layout. Moreover, I/O pins are standardized. With such features as these, the standardization of the power supply layers reduces the manhour of design of the multilayer interconnection substrate and the number of print masks to be prepared. The position of each of the through holes is also standardized. When various kinds of multilayer interconnection substrates are fabricated, the standardization of the power supply layers and the positions of the through holes makes the process of fabrication of the multilayer interconnection substrate less complicated than the prior art, resulting in ease of fabrication of the multilayer interconnection substrate. Thus, the time of development of the product and cost of fabrication are reduced.

One or some of the power supply layers may be applied with a voltage of ground throughout the embodiments of the present invention.

## Claims

1. A multilayer interconnection substrate having a component mounting surface for mounting components thereon, comprising:
signal layers;
power supply layers;
at least one power supply matching layer, layered above both the signal layers and the power supply layers and close to the component mounting surface; each power supply matching layer being provided to correspond to respective voltages of the components to be mounted to the component mounting surface;
insulating layers for electrically insulating the signal layers, the power supply layers and the power supply matching layer from each other;
said signal layers, said power supply layers, said power supply matching layer and the insulating layers being superposed into a laminate;

component connection terminal means, mounted to the component mounting surface, for connection to the component; said component connection terminal means including component power supply terminals;

external connection terminal means mounted to another surface of the multilayer interconnection substrate; said external connection terminal means including external power supply terminals; and

interconnecting means including: first power supply interconnection means for interconnecting said at least one power supply matching layer to corresponding component power supply terminals; second power supply interconnection means for interconnecting the power supply matching layer to corresponding power supply layers; and third power supply interconnecting means for interconnecting said at least one power supply matching layer to corresponding external power supply terminals.

2. A multilayer interconnection substrate according to Claim 1, wherein:

the signal layers, the power supply layers and the power supply matching layer have each a corresponding conductor pattern sandwiched between adjacent insulating layers; and

the interconnecting means comprises through holes formed through at least some of the insulating layers.

3. A multilayer interconnection substrate having component mounting surfaces for mounting components thereon, comprising:

signal layers;

power supply layers;

at least two power supply matching layers which are respectively layered above and below both the signal layers and the power supply layers and close to the component mounting surfaces; each power supply matching layer being provided to correspond to respective voltages of the components to be mounted to the component mounting surfaces;

insulating layers for electrically insulating the signal layers, the power supply layers and the power supply matching layer from each other;

said signal layers, said power supply layers, said power supply matching layers and the insulating layers being superposed into a laminate;

component connection terminal means, mounted to the component mounting surfaces, respectively, for connection to the components; said component connection terminal means including component power supply terminals;

external connection terminal means mounted to another surface of the multilayer interconnection substrate; said external connection terminal means including external power supply terminals; and

interconnecting means including: first power supply interconnection means for interconnecting said power supply matching layers to corresponding component power supply terminals; second power supply interconnection means for interconnecting the power supply matching layer to corresponding power supply layers; and third power supply interconnection means for interconnecting said power supply matching layer to corresponding external power supply terminals.

4. A multilayer interconnection substrate according to Claim 3, wherein:

the component connection terminal means comprises signal terminals;

the external connection terminal means comprises external signal terminals; and

the interconnecting means comprises: first signal interconnection means for interconnecting the signal terminals of the component connection terminal means to corresponding signal layers; and second signal interconnection means for interconnecting the signal terminals of the external connection terminal means to corresponding signal layers.

5. A multilayer interconnection substrate according to Claim 4, further comprising:

an external connector adapted to connect to the external power supply terminals and the external signal terminals;

said external connector being mounted to the another surface of the multilayer interconnection substrate.

6. A multilayer interconnection substrate according to Claim 1 wherein:

the component connection terminal means comprises signal terminals;

the external connection terminal means comprises external signal terminals; and

the interconnecting means comprises: first signal interconnection means for interconnecting the signal terminals of the component connection terminal means to corresponding signal layers; and second signal interconnection means for interconnecting the external signal terminals of the external connection terminal means to corresponding signal layers, and

further comprising:

I/O pins connected to respective external signal terminals and external power supply terminals.

7. a multilayer interconnection substrate according to Claim 1, wherein:

the component connection terminal means comprises signal terminals;

the external connection terminal means comprises external signal terminals; and

the interconnecting means comprises: first signal interconnection means for interconnecting the signal terminals of the component connection terminal means to corresponding signal layers; and second signal interconnection means for interconnecting the external signal terminals of the external connection terminal means to corresponding signal layers; and
wherein:
both the signal terminals and the power supply terminals of the component connection terminal means are separated in groups, each group being arranged at a corresponding chip site on the component mounting surface, the chip site being adapted to have a corresponding component mounted thereat.

8. A multilayer interconnection substrate according to Claim 7, wherein the first power supply interconnection means and the first signal interconnection means have each the same arrangement pattern as to every group of component connection terminal means.

9. A chip carrier having opposite surfaces, one surface being adapted to support a semiconductor chip, the chip carrier comprising:
at least one power supply matching layer corresponding in voltage to the semiconductor chip;
insulating layers sandwiching the power supply matching layer, the insulating layers and power supply matching layer being superposed;
chip connection terminal means, mounted on one surface of the chip carrier, for connection to the semiconductor chip, the chip connection terminal means including chip power supply terminals;
substrate connection terminal means, mounted on the other surface of the chip carrier, for connection to a multilayer interconnection substrate, the substrate connection terminal means including substrate power supply terminals; and interconnecting means for interconnecting each of both the chip power supply terminals and the substrate power supply terminals to a corresponding power supply matching layer.

10. A semiconductor integrated circuit device including a semiconductor chip, a chip carrier for supporting the semiconductor chip; and a multilayer interconnection substrate having the chip carrier mounted thereon, wherein:
the chip carrier has opposite surfaces, one surface thereof having the semiconductor chip mounted thereon;
the chip carrier comprises: at least one power supply matching layer corresponding in voltage to the semiconductor chip; insulating layers sandwiching the power supply matching layer, the insulating layers and power supply matching layer being superposed;
chip connection terminal means, mounted on one surface of the chip carrier, for connecting to the semiconductor chip, the chip connection terminal means including chip power supply terminals;
substrate connection terminal means, mounted on the other surface of the chip carrier, for connecting to the multilayer interconnection substrate, the substrate connection terminal means including substrate power supply terminals; and
interconnecting means for interconnecting each of both the chip power supply terminals and the substrate power supply terminals to the power supply matching layer.

11. In a semiconductor integrated circuit device including a semiconductor chip and a multilayer interconnection substrate for supporting the semiconductor chip, the multilayer interconnection substrate having a chip mounting surface, the multilayer interconnection substrate comprising:
signal layers;
a power supply layers;
at least one power supply matching layer, layered above both the signal layers and the power supply layers and close to the chip mounting surface, the power supply matching layer corresponding in voltage to the semiconductor chip;
insulating layers for electrically insulating the signal layers, the power supply layers and the power supply matching layer from each other, the signal layers, the power supply layers, the power supply matching layer and the insulating layers being superposed;
component connection terminal means, mounted to the component mounting surface for connecting to the semiconductor chip, the component connection terminal means including component power supply terminals;
external connection terminal means mounted to another surface of the multilayer interconnection substrate, the external connection terminal means including signal I/O pins and power supply I/O pins; and
interconnecting means including first power supply interconnection means for interconnecting the power supply matching layer to corresponding component power supply terminals, second power supply interconnection means for interconnecting the power supply matching layer to corresponding power supply layers, and third power supply interconnection means for interconnecting the power supply matching layer to corresponding power supply I/O pins.

12. A semiconductor integrated circuit device according to Claim 11, wherein:
the signal layers, the power supply layers and the power supply matching layer have each a corresponding conductor pattern sandwiched between adjacent insulating layers; and
the interconnecting means comprises through holes formed through at least some of the insulating layers.

13. A multilayer interconnection substrate having a chip mounting surface, the multilayer interconnection substrate comprises:

signal layers;

power supply layers;

at least one power supply matching layer, layered above both the signal layers and the power supply layers and close to the chip mounting surface, the power supply matching layer corresponding in voltage to a semiconductor chip to be mounted on the chip mounting surface;

insulating layers for electrically insulating the signal layers, the power supply layers and the power supply matching layer from each other, the signal layers, the power supply layers, the power supply matching layer and the insulating layers being superposed;

component connection terminal means, mounted to the component mounting surface for connecting to the semiconductor chip, the component connection terminal means including component power supply terminals;

external connection terminal means mounted to another surface of the multilayer interconnection substrate, the external connection terminal means including signal I/O pins and power supply I/O pins; and

interconnecting means including first power supply interconnection means for interconnecting the power supply matching layer to corresponding component power supply terminals, second power supply interconnection means for interconnecting the power supply matching layer to corresponding power supply layers, and third power supply interconnection means for interconnecting the power supply matching layer to corresponding power supply I/O pins.

14. A multilayer interconnection substrate having a component mounting surface for mounting components thereon, comprising:

signal layers;

power supply layers;

a bus-bar layer or layers, provided in the number corresponding to varieties of voltages which are required by the components to be mounted on the component mounting surface, for supplying power of the required voltages to the respective components;

insulating layers for electrically insulating the layers from each other;

the signal layers, the power supply layers, the bus-bar layers and the insulating layers being superposed into a laminate; and

interconnecting means for interconnecting the power supplying layer or layers of the same voltage with the corresponding bus-bar layers, respectively.

15. A multilayer interconnection substrate having a surface for mounting components thereon, comprising:

signal layers;

power supply layers adapted to have voltages desired by the respective components;

bus-bar layers provided for the respective voltages and electrically connected to the power supply layers of the corresponding voltages, respectively, for supplying the power of desired voltages to the components through the bus-bar layers of the corresponding voltages, respectively; and

insulation layers;

said signal layers, said power supply layers and said bus-bar layers being superposed into a laminate, while interposing the insulation layers between any two adjacent layers.

# FIG. 1

# FIG. 2

# F I G.3

# F I G . 4

# F I G . 5

# FIG. 6

# FIG. 7

FIG. 8

# F I G . 9

EP 0 414 204 A2